Europäisches Patentamt

European Patent Office

Office européen des brevets

(11) Publication number: **0 138 078**
**A2**

# EUROPEAN PATENT APPLICATION

(21) Application number: **84111018.2**

(22) Date of filing: **14.09.84**

(51) Int. Cl.⁴: **H 03 M 13/00**

(30) Priority: **15.09.83 IT 6795583**

(43) Date of publication of application: **24.04.85**
**Bulletin 85/17**

(84) Designated Contracting States: **BE CH DE FR GB LI NL**
**SE**

(71) Applicant: **CSELT Centro Studi e Laboratori**
**Telecomunicazioni S.p.A., Via Guglielmo Reiss**
**Romoli, 274, I-10148 Turin (IT)**

(72) Inventor: **Bessone, Danilo, V. Monginevro, 4, S.**
**Ambrogio (To) (IT)**
Inventor: **Fersini, Dario, Via O. Vigliani, 201, Turin (IT)**

(74) Representative: **Riederer Freiherr von Paar zu Schönau,**
**Anton et al, Freyung 615 Postfach 2664, D-8300 Landshut**
**(DE)**

(54) Decoder of cyclic perfect binary code.

(57) A decoder of cyclic perfect binary code comprising a modulo-2 adder of the redundancy word received and of a word read from a first table of redundancy words addressed by the received data word: the adder output is the syndrome of the received coded word. The decoder comprises a second modulo-2 adder which supplies at the output the corrected data word as addition of the data word received and of a correction word read from a second table addressed by the syndrome obtained: the correction word addresses the bits of the received data word which are possibly to be corrected.

- Dipl.-Ing. Anton Freiherr
**Riederer von Paar**
D-8300 Landshut
Postfach 2664, Freyung 615
☏ Landshut (0871) 22170
Fax (CCITT 2) manuell
Telex 58441 glala d

0138078

Frhr. Riederer v. Paar, Postfach 2664, D-8300 Landshut

CSELT Centro Studi e Laboratori
Telecomunicazioni S.p.A.

Turin, Italy

Partner in München:
**Dr. H. O. DIEHL**
☏ München (089) 177061
Fax (089) 177461 (autom.)
Telex 5215145 Zeus d

## Decoder of Cyclic Perfect Binary Code

### 1 Description

The present invention relates to the encoded-data receiving circuits, and in particular it concerns a decoder for a binary code of the perfect cyclic type.

Perfect cyclic codes are a particular family of codes allowing detection and correction, in reception, of transmission errors up to a given maximum number of errors per coded word, said maximum number being characteristic of the code used; this is possible because the remainder of the division of the coded word with the generator polynomial, which remainder is the so-called syndrome, allows one-to-one identification of the positions of the coded words where said errors reside. If the syndrome has a value equal to zero, no error exists.

Each coded word is formed by a data word and an appended check word, formed by a certain number of redundancy bits and hereinafter referred to as redundancy word.

It is to be appreciated that transmission error(s) can take place both in the data word and in the redundancy word.

The importance is evident of the use of said codes in particular application fields, such as for instance in satellite communications wherein the information present in a number of channels, e.g. command and signalling channels, is coded in that way since requesting retransmission in case of errors would be too slow and expensive. It is preferable to use codes allowing detection and correction of erroneous bits, up to a maximum number per coded word, by means of a suitable device called code-decoder.

Code-decoders, which are already known in the art, as for instance that described in the article by L.J. Rennie "Forward-looking error correction via extended Golay", Computer Design, June 1982, pages 121-130, present the disadvantage of too complex circuit structures, which are not suitable to be used in the cases in which the computing rate and the physical space occupied by the circuit are determinant.

The decoder described in the cited paper comprises a syndrome calculating circuit and an error correcting circuit. The syndrome calculating circuit effects the division of each received coded word by the generator polynomial to obtain the syndrome which is supplied to the error correcting circuit. The latter consists of a processing unit implementing a rather complex correcting algorithm which, by calculating the number of bits at "1" in the syndrome, checks whether the errors are confined in the redundancy bits and hence whether the data word is correct: if it isn't, it starts an iterative procedure which, through shift operations on the coded word, recalculation of the new syndrome and of the number of bits at "1" in the same, detects and corrects the erroneous bits in the data word.

Such a decoding structure does not permit high computing rate, because it is complex and cumbersome.

Said problems are solved by the present invention of a decoder of a perfect cyclic binary code, which requires no dividing circuit, but obtains the syndrome of the received coded word by a simple modulo-2 addition of the received redundancy word with a word read from a table addressed by the data word received and wherein the redundancy words corresponding to all the possible data words are stored.

In addition it obtains the correct data word by another modulo-2 addition of the received data word and a correction word, read from a second table addressed by the just obtained syndrome: each correction word identifies the possible bits to be corrected in the received data word.

It is provided by the present invention a decoder of perfect cyclic binary code as described in claim 1.

The foregoing and other characteristics of the present invention will become clearer from the following description of a preferred embodiment of the same and of an alternative embodiment given by way of non limiting examples with reference to the annexed drawing in which:

- Fig. 1 shows a circuit diagram of the decoder provided by the invention,

- Fig. 2 shows an alternative embodiment of the circuit block denoted by TAB1 in fig. 1

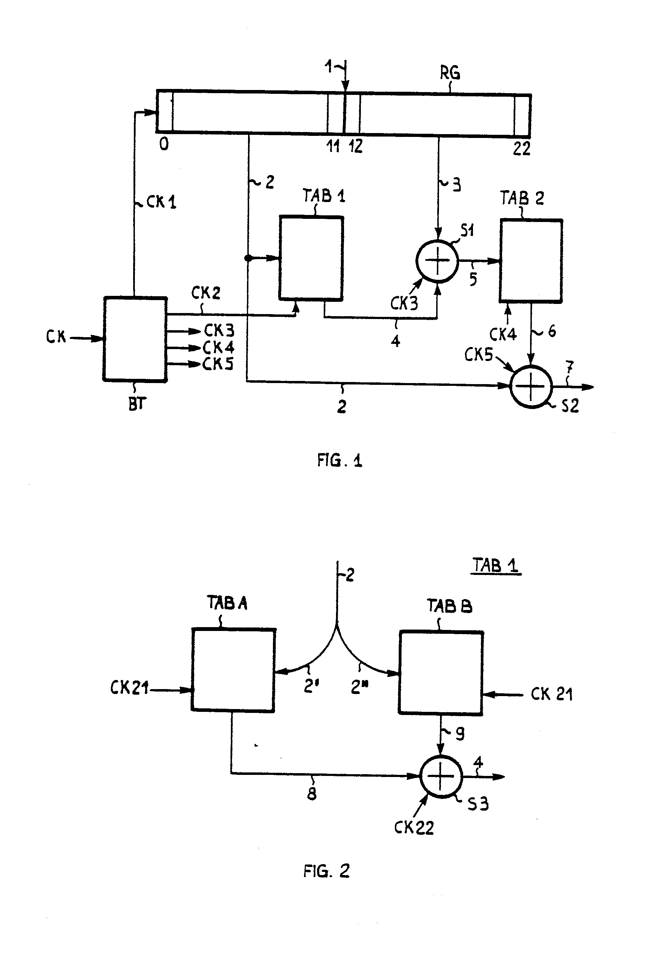

Fig.1 shows an example of a decoder relevant to the non limiting case of words coded by the Golay code(23, 12),having a 23-bit coded word:that's a 12-bit data word and a 11-bit redundancy word.

In Fig. 1 reference 1 denotes a data input bus of the decoder, on which there are present in sequence the coded words in parallel.

Bus 1 is connected to a normal register RG with the capacity of one coded word.

In the example described here bus 1 consists of 23 wires and register RG of 23 cells; the first 12 cells (positions 0-11) contain the data word, while the remaining 11 cells (positions 12-22) contain the redundancy word.

Each data word is rendered available in parallel form on bus 2 of 12 wires, and each redundancy word on bus 3 of 11 wires.

TAB1 denotes a block basically comprising a table of 11-bit configurations of all the redundancy words (associated with the corresponding data words) generated in accordance with the code algorithm of Golay code, described for instance in the paper above.

Redundancy words are written in TAB1 in such positions that at the address given by the data word and carried through bus 2, there is present the corresponding redundancy word. TAB1 consists of a ROM where there are 4,096 redundancy words, corresponding to $2^{12}$ possible bit configurations on bus 2.

Redundancy words read in this way are carried, through 11-wire bus 4, to an input of a modulo-2 adder S1, to the second input of which the redundancy words present on bus 3 are transferred.

Adder S1 consists of EX-OR logic circuits, each receiving at the input a pair of corresponding wires of buses 3 and 4.

Each EX-OR circuit is connected at the output to the corresponding wire of bus 5 where it supplies a logic "1" if the bits at its inputs have opposite logic values, or a logic "0" if the bits at its inputs have the same logic values.

The words present on bus 5 are the syndrome of the corresponding coded words present in register RG, regardless of the position of the erroneous bits inside the coded words.

TAB2 denotes a ROM containing the table of all the possible error configurations which may take place in data word up to a maximum of three erroneous bits per each word (so many may be corrected by Golay code) by the following convention: in the positions corresponding to the erroneous bits there is stored a logic 1, in the others a logic 0.

A table of correction words of 12 bits each is obtained. Said words are written in TAB2 at the addresses consisting of the relevant syndrome, so that each syndrome present on bus 5 forms the address for the reading in TAB2 of the corresponding correction word supplied at the output on bus 6.

S2 denotes a modulo-2 adder equivalent to S1, containing 12 EX-OR logic circuits, one per each wire of its input buses 2 and 6.

The task of S2 is that of changing the logic level in the positions of bus 2 carrying an erroneous bit, so that on the output bus 7 of S2 and of the decoder there is present the original correct word.

BT denotes a usual time-base synchronized by signal CK coming from the outside and which can be e.g. the clock signal controlling the data flow on bus 1, and is supplied by the same device sending the data onto bus 1.

BT supplies the clock signals CK1, CK2, CK3, CK4, CK5, duly phase-shifted, respectively to RG, TAB1, S1, TAB2, S2.

Fig. 2 shows a possible alternative embodiment of block TAB1 of Fig. 1.

Perfect cyclic codes have the property that by the modulo-2 addition of two code words a code word can be still obtained.

By exploitation of this property, each original 12-bit word is split into two data words A and B still of 12 bits so composed:
- word A: formed by the bits of positions 0 to 5 of the original data word in its positions 0 to 5, and of logic 0s in its positions 6 to 11;
- word B: composed of the bits of positions 6 to 11 of the original data word in its positions 6 to 11 and of logic 0s in its positions 0 to 5.

The redundancy words associated with the sets of words A and B are then generated by the Golay code algorithm. The redundancy words relevant to words A are stored in ROM TABA and those relevant to words B in TABB, in such positions that the significant portion of words A and B (positions 0 to 5 of A and 6 to 11 of B) forms the reading address of said redundancy words.

Finally the data word present in register RG (Fig. 1) and on bus 2 (Fig. 2) is divided into two halves: the first half (positions 0 to 5) through bus 2' addresses table TABA which, on bus 8 of 11 wires, supplies the redundancy word relevant to word A; the second half (positions 6 to 11), through bus 2'', addresses table TABB which on bus 9, this too made of 11 wires, supplies the redundancy word relevant to word B.

Buses 8 and 9 are connected to modulo-2 adder S3 equal to S1 of fig. 1.

Owing the above-cited addition property, by the modulo-2 addition of the redundancy words corresponding to words A and B, the redundancy word corresponding to the data word present in RG (Fig. 1) is obtained at the output of S3 on bus 4.

It can be easily verified that by implementing block TAB1 as described in Fig. 2, two memories are sufficient, each of capacity equal to $2^6=64$ words, while a further computing step is introduced, the one executed by adder S3.

Clock signal CK2 of Fig. 1 is now replaced by the clock signals CK21, carried to TABA and TABB, and CK22, carried to S3. CK21 and CK22 must be duly shifted.

The original data word might be split into more than two component words; this solution would give rise to a further reduction in the total memory dimension of TAB1, but would entail also the introduction of further modulo-2 addition steps, with consequent reduction in the global computing rate of the decoder.

The solution shown in Fig. 2 represents the best compromise between computing rate and capacity of memory TAB1, while the solution shown in Fig. 1 permits the highest computing rate, but requires a higher capacity of memory TAB1 which, as mentioned, is composed of $2^{12}=4.096$ words.

PATENTANWÄLTE

Dipl.-Ing. Anton Freiherr
Riederer von Paar
01 38078
D-8300 Landshut
Postfach 2664, Freyung 615
☎ Landshut (0871) 22170
Fax (CCITT 2) manuell
Telex 58441 glala d

Frhr. Riederer v. Paar, Postfach 2664, D-8300 Landshut

CSELT Centro Studi e Laboratori
Telecomunicazioni S.p.A.

Turin, Italy

Partner in München:
**Dr. H. O. DIEHL**
☎ München (089) 177061
Fax (089) 177461 (autom.)
Telex 5215145 Zeus d

Decoder of Cyclic Perfect Binary Code

**Patent Claims**

1. Decoder of words coded in binary code of the perfect cyclic type, said coded words being composed each of a data and of a redundancy word, characterized in that it comprises:

   - a register (RG), of the capacity of a coded word, which temporarily stores said coded words which it receives at the input, and supplies at the output on a first bus (2) the data word and on a second bus (3) the redundancy word;

   - a storage unit (TAB1) containing the redundancy words associated with all the data word configurations, said unit being addressed by the data word present in the first bus (2) and supplying on a third bus (4) the corresponding redundancy word;

   - a first modulo-2 adder (S1) of the redundancy words present on said second (3) and third (4) bus, which supplies at the output on a fourth bus (5) the result of the addition forming the syndrome of the coded word;

   - a first ROM memory (TAB2) containing a table of correction words detecting the positions of data words, present on the first bus (2), containing errors, said correction words being stored in the table in such positions that the syndromes present on the fourth bus (5) form the reading addresses of said stored words, and being supplied at the output on a fifth bus (6);

- a second modulo-2 adder (S2) of the correction words present on the fifth bus (6) and of the data words present on the first bus (2), which adder supplies at the output (7), which is the decoder output, the corrected data words.

2. Decoder as in claim 1, characterized in that said storage unit (TAB1) basically consists of a memory of the ROM type where redundancy words are stored in such positions that the corresponding data words present on the first bus (2) form the reading addresses of said stored words.

3. Decoder, as in claim 1, characterized in that said storage unit (TAB1) comprises:

- a second ROM memory (TABA) containing the redundancy words associated with data words composed, in the first positions, of a first portion of the data words present in said register (RG) and of logic 0 in the remaining positions, said redundancy words being stored in such positions that said first portion of the data words, present on the first bus (2), forms the reading address of said stored words, and being supplied on a seventh bus (8);

- a third ROM memory (TABB) containing the redundancy words associated with data words composed of logic 0 in the first positions and in the remaining positions of a second part of said data words present in said register (RG), said redundancy words being stored in such positions that said second part of the data words present on the first bus (2) forms its reading address, and being supplied on an eighth bus (9);

- a third modulo-2 adder (S3) of the redundancy words present on said seventh (8) and eighth (9) bus, which supplies at the output the redundancy words on said third bus (4).

FIG. 1

FIG. 2